# EUROPEAN PATENT SPECIFICATION

(11) **EP 4 270 018 B1**
(45) Date of publication and mention of the grant of the patent: **04.11.2026**
(21) Application number: 22759106.2
(22) Date of filing: 06.01.2022
(51) Int. Cl.: G01R 15/20

(54) **CURRENT SENSOR**
STROMSENSOR
CAPTEUR DE COURANT

(30) Priority: 24.02.2021 JP 2021027016
(43) Date of publication of application: 01.11.2023
(73) Proprietor: Suncall Corporation, Kyoto-shi, Kyoto 615-8555 (JP)
(72) Inventor: MUGISHIMA, Akio, Kyoto-shi Kyoto 615-8555 (JP); MURAKAMI, Kenji, Kyoto-shi Kyoto 615-8555 (JP)
(74) Representative: Hoffmann Eitle
(86) International application number: PCT/JP2022/000163
(87) International publication number: WO 2022/181063

(56) References cited:
- WO-A1-2019/220766
- CN-A- 101 640 397
- CN-U- 210 894 464
- JP-A- 2001 059 851
- JP-A- 2012 141 262
- JP-A- 2012 141 262
- JP-A- 2013 053 914
- JP-A- 2013 113 631
- JP-A- 2013 113 631
- US-A1- 2010 156 394
- US-A1- 2011 148 407
- US-A1- 2019 187 187

## Description

### TECHNICAL FIELD

The present invention relates to a current sensor.

### BACKGROUND

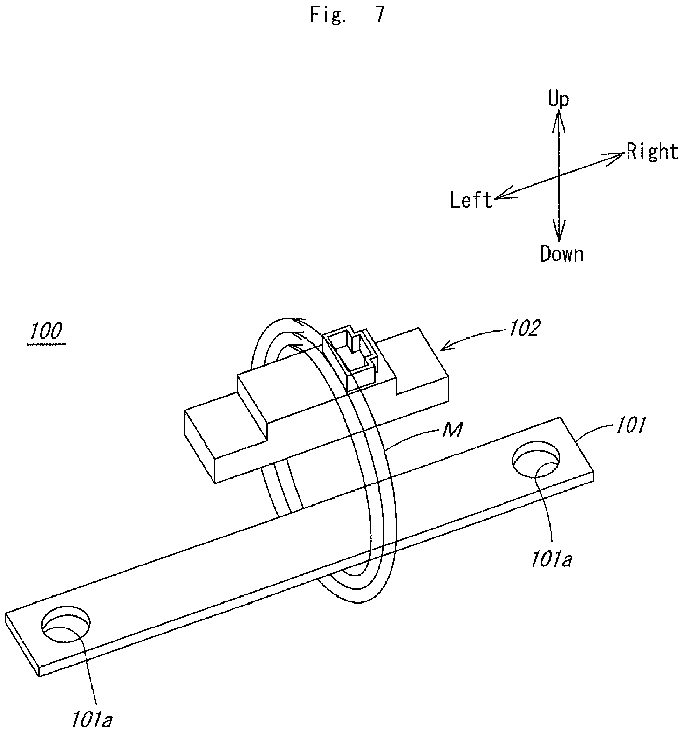

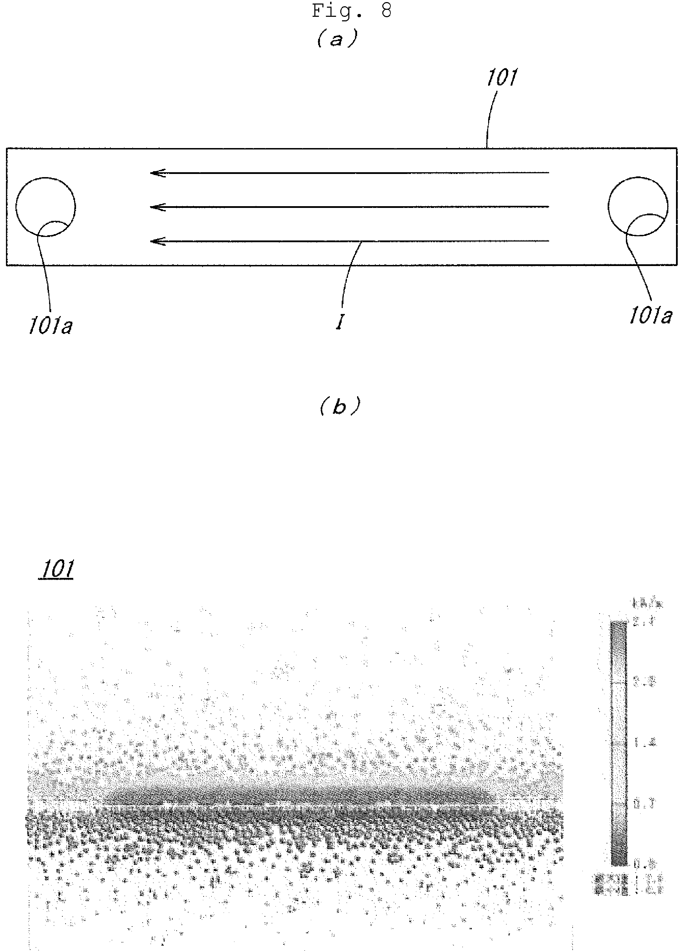

For a current sensor, such as one described in JP 2010-14477 A, is known as a conventional one. As shown in FIG. 7, the current sensor 100 comprises a bus bar 101 through which a current I (see FIG. 8(a)) to be measured flowing, and a magnetic sensor 102 arranged at a position separated from the bus bar 101 in a vertical m direction with respect to the bus bar 101, and detecting a magnetic field component M generated in a direction perpendicular to the current I flowing through the bus bar 101. Circular bolt holes denoted by 101a are for passing shaft of bolts (not shown).

A current sensor (related to the preamble of claim 1) is described in JP 2012 141 262 A. A current sensor is also known from US 2011/148 407 A1, JP 2013 113 631 A, CN 101 640 397 A, and US 2019/187 187 A1.

### SUMMARY OF THE INVENTION

### TECHNICAL PROBLEM

The magnetic sensor 102 set forth above has large variations in sensitivity in product performance, so it is necessary to adjust the magnetic sensor 102 in the vertical upward direction or the vertical downward direction in order to adjust the detection sensitivity when the magnetic sensor 102 detects the magnetic field component M. That is, as shown in FIG. 8(a), when the current I to be measured flows through the bus bar 101, the magnetic field component M is generated in a direction perpendicular to the current I as shown in FIG. 7. In this case, it can be seen from the measurement result of a magnetic flux density shown in FIG. 8(b) that a homogeneous M is generated at any surfaces of the magnetic sensor 102. Therefore, the location where the variations of intensity of the magnetic field component M occur are only in the vertical upward direction or the vertical downward direction with respect to the bus bar 101 (when the magnetic sensor 102 approaches the bus bar 101, the magnetic field component M becomes stronger, and when the magnetic sensor 102 is separated from the bus bar 101, the magnetic field component M becomes weaker). Therefore, it was necessary to adjust the magnetic sensor 102 vertically upward or vertically downward in order to adjust the sensitivity of the detection. Incidentally, adjusting the sensitivity of the detection means, for example, adjusting the magnetic sensor 102 so that a voltage of 1V can be detected when the current I of 100A flows through the bus bar 101.

As aforementioned, when the magnetic sensor 102 is adjusted in the vertical upward direction or the vertical downward direction with respect to the bus bar 101, there has been a problem that the installation area of the current sensor 100 increases. Further, because the magnetic sensor 102 must be arranged away from the bus bar 101, adjustment work is difficult, which may have occurred problems such as measurement errors and lower measurement accuracy.

The present invention has hence been made in consideration of the above-described problem, and an object thereof is to provide a current sensor capable of saving the installation area and improving the measurement accuracy.

### MEANS FOR SOLVING THE PROBLEM

The foregoing object of the present invention is achieved by the following means. It is noted that reference signs in the embodiments to be described hereinafter are added in parentheses, but the present invention is not intended to be limited thereto.

A current sensor of the present invention is defined in claim 1.

### ADVANTAGEOUS EFFECTS OF THE INVENTION

Next will be described advantageous effects of the present invention with reference signs in the drawings. It is noted that reference signs in the embodiments to be described hereinafter are added in parentheses, but the present invention is not intended to be limited thereto.

According to the present invention, the bus bar (2, 2A, 2B, 2C, 2D) is provided with a changer (left through-hole 2h1, right through-hole 2h2, upper notch 2hA1, lower notch 2hA2, upper notch 2hB1, lower notch 2hB2, upper notch 2hC1, lower notch 2hC2, upper protrusion 2hD1, lower protrusion 2hD2) that can change the flow of the current (I) to be measured, so that variations of intensity of the magnetic field component (M) can be generated on the surface of the bus bar (2, 2A, 2B, 2C, 2D). This eliminates the need to adjust the magnetic sensor (102) in the vertical upward direction or the vertically downward direction with respect to the bus bar (2, 2A, 2B, 2C, 2D) as is conventional, thereby the installation area of the current sensor can be reduced.

Further, since the magnetic sensor (102) is mounted on the upper surface (2a) of the bus bar (2, 2A, 2B, 2C, 2D), it is not necessary to adjust the magnetic sensor (102) away from the bus bar (2, 2A, 2B, 2C, 2D). This facilitates the adjustment work and makes the measurement error less likely to occur, thus improves the measurement accuracy.

According to the present invention, the installation area of the current sensor can be reduced and the measurement accuracy can be improved.

The changer is preferably composed of at least one of the through-holes (left through-hole 2h1, right through-hole 2h2), recessed holes, notches (upper notch 2hA1, lower notch 2hA2, upper notch 2hB1, lower notch 2hB2, upper notch 2hC1, lower notch 2hC2), or protrusions (upper protrusion 2hD1, lower protrusion 2hD2). This can generate the variations of intensity of the magnetic field component (M) on the surface of the bus bar (2, 2A, 2B, 2C, 2D).

When the changer is composed of the through-hole (left through-hole 2h1, right through-hole 2h2), the through-hole is made to be served as a changer of the flow of the current (I) to be measured and served as a screw fixing for the magnetic sensor (102) to the upper surface (2a) of the bus bar (2, 2A, 2B, 2C, 2D). This eliminates the need to make other holes with separate roles in the bus bar (2, 2A, 2B, 2C, 2D), thereby simplifying the manufacturing process of the current sensor.

### BRIEF DESCRIPTION OF THE DRAWINGS

FIG. 1 is an exploded perspective view of a current sensor according to an embodiment of the present invention, which is not encompassed by the wording of the claims.
FIG. 2 is a perspective view of the current sensor according to the same embodiment, which is not encompassed by the wording of the claims.
FIG. 3 (a) is a plan view of the bus bar according to the same embodiment explaining a state in which a current flows through the bus bar, which is not encompassed by the wording of the claims; and FIG. 3 (b) is a diagram showing a measurement result of a magnetic flux density generated when the FIG. 3 (a) is viewed from the side.
FIG. 4 (a) is a perspective view of a variation of the bus bar explaining a state in which a current flows through the bus bar, which is not encompassed by the wording of the claims; and FIG. 4 (b) is a diagram showing a measurement result of a magnetic flux density generated when the FIG. 4(a) is viewed from the side.
FIG. 5 (a) is a perspective view of a variation of the bus bar, which is not encompassed by the wording of the claims; and FIG. 5 (b) is a perspective view of another variation of the bus bar.
FIG. 6 (a) is a perspective view of a variation of a bus bar explaining a state in which a current flows through the bus bar; and FIG. 6 (b) is a diagram showing a measurement result of a magnetic flux density generated when the bus bar in FIG. 6 (a) is viewed from the side.
FIG. 7 is a perspective view of a conventional current sensor.
FIG. 8 (a) is a plan view of the conventional bus bar explaining a state in which a current flows through the bus bar; and FIG. 8 (b) is a diagram showing a measurement result of a magnetic flux density generated when the bus bar in FIG.8 (a) is viewed from the side.

### DESCRIPTION OF THE EMBODIMENTS

Hereinafter, an embodiment of a current sensor according to the present invention, which is not encompassed by the wording of the claims, will be specifically described with reference to the drawings. It is noted that, in the following description, when vertical and horizontal directions are indicated, it shall mean vertical and horizontal directions when viewed from the front of the figure. Also, it should be noted that components identical to those as conventional are designated by the same reference signs to omit the description thereof.

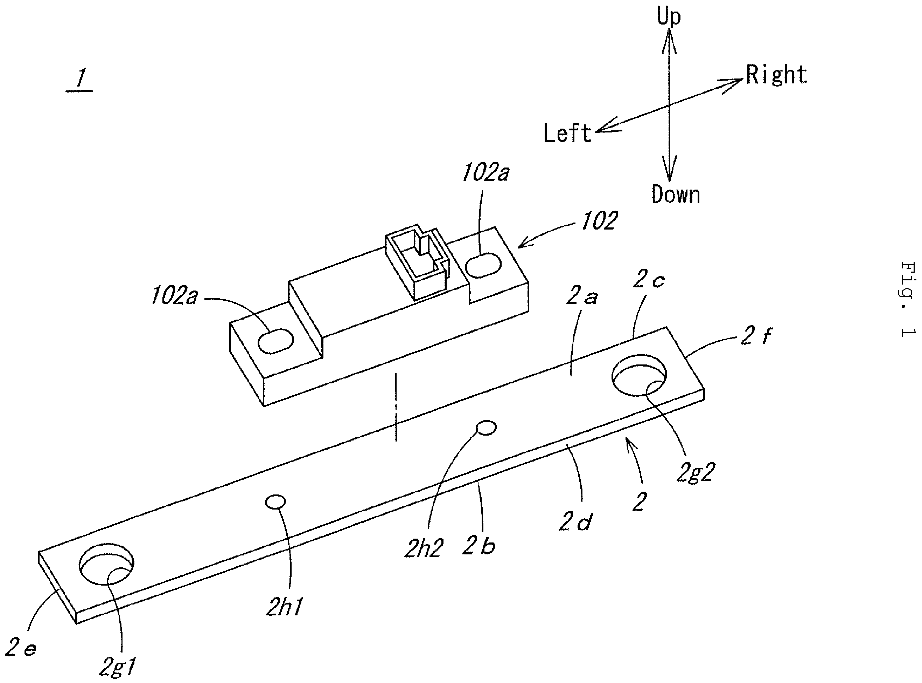

The current sensor according to the present embodiment, which is not encompassed by the wording of the claims, is used in an in-vehicle inverter, an on-vehicle battery, or the like. As shown in FIG. 1, the current sensor 1 is composed of a bus bar 2 and a magnetic sensor 102.

The bus bar 2 is made of a metal such as a copper, and as shown in FIG. 1 for example, it is formed in a thick plate with a thickness of about 3 mm to 5 mm and is formed in a long rectangular shape having an upper surface 2a, a lower surface 2b, an upper side surface 2c, a lower side surface 2d, a left side surface 2e, and a right side surface 2f. At a side close to a left side surface 2e of the bus bar 2 a circular bolt hole 2g1 for passing a shaft part of a bolt (not shown) is formed so as to penetrate in a vertical direction, and also at a side close to a right side surface 2f of the bus bar 2 a circular bolt hole 2g2 for passing a shaft part of a bolt (not shown) is formed so as to penetrate in a vertical direction.

Furthermore, as shown in FIG. 1, at a center of the bus bar 2 slightly closer to the left side surface 2e, a left through-hole 2h1 to penetrate from the upper surface 2a toward the lower surface 2b is formed, and at the center of the bus bar 2 slightly closer to the right side surface 2f, a right through-hole 2h2 to penetrate from the upper surface 2a toward the lower surface 2b is formed.

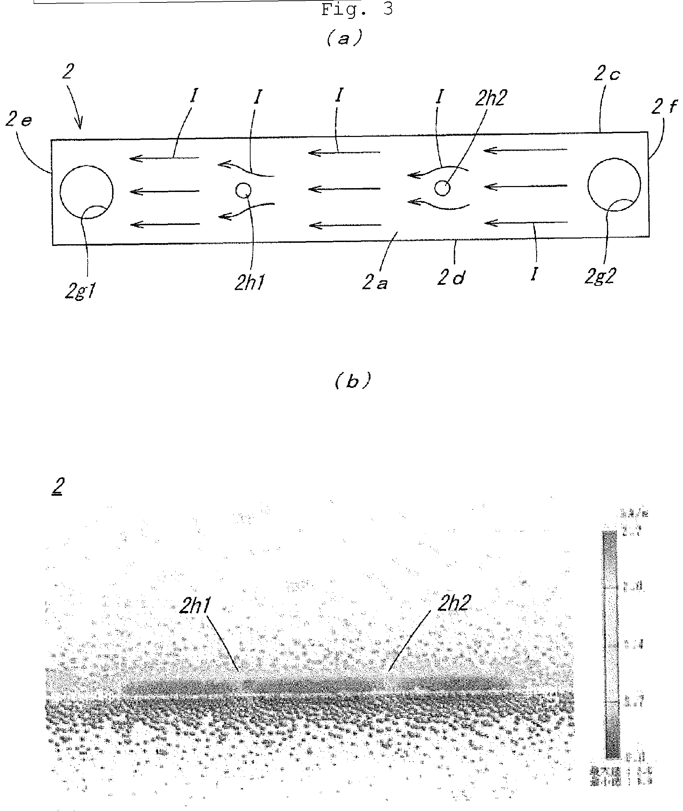

In the configuration such that the left through-hole 2h1 and the right through-hole 2h2 set forth above are formed in the bus bar 2, as shown in FIG. 3(a) when the current I to be measured linearly flows from the right side surface 2f to the left side surface 2e of the bus bar 2, the current I that was linearly flowing is curved so as to bypass the right through-hole 2h2, and further the current I linearly flowing is curved so as to bypass the left through-hole 2h1. Thereby the current path of the current I is made to be changed by the left through-hole 2h1 and the right through-hole 2h2. Therefore, when the current I to be measured flows linearly from the right side surface 2f to the left side surface 2e of the bus bar 2, a magnetic field component M (see FIG. 7) is generated in a direction perpendicular to the current I, while as will be apparent from a measurement result of a magnetic flux density shown in FIG. 3(b), a tense of the magnetic field component M in the vicinity of the left through-hole 2h1 and the right through-hole 2h2 clearly becomes weaker as compared to other points by the current I avoiding around the left through-hole 2h1 and the right through-hole 2h2. Accordingly, by forming the left through-hole 2h1 and the right through-hole 2h2 in the bus bar 2, the variation of intensity of the magnetic field component M can be generated on the surface of the bus bar 2.

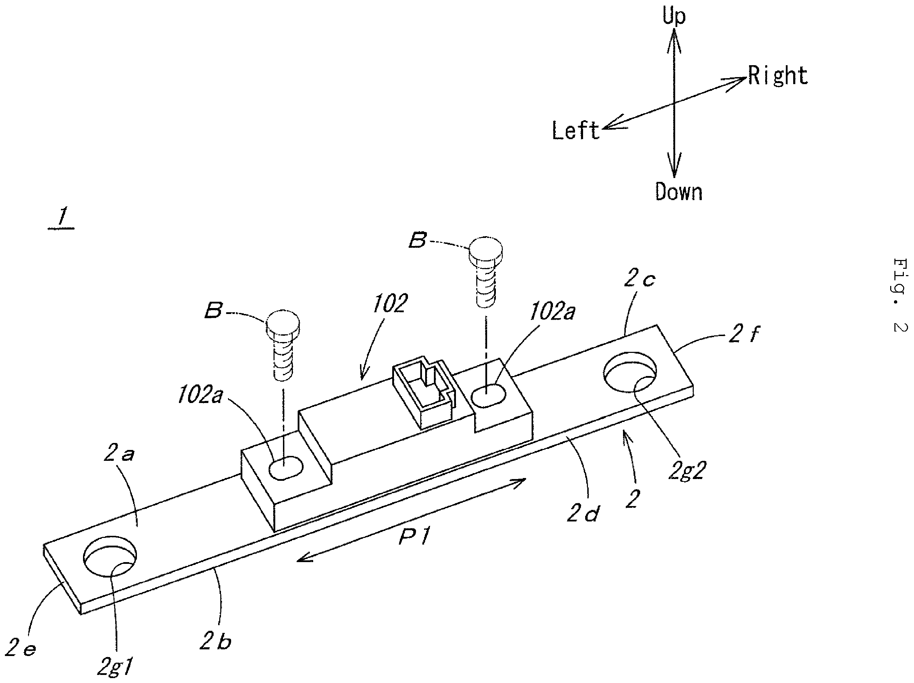

Thus, since the variation of intensity of the magnetic field component M can be generated on the surface of the bus bar 2, in an order to adjust the sensitivity of the detection of the magnetic sensor 102, it is no longer needed to adjust the magnetic sensor 102 vertically upward or vertically downward with respect to the bus bar 2 as is conventional, and as shown in FIG. 2, the sensitivity of the detection of the magnetic sensor 102 can be adjusted only by moving the magnetic sensor 102 in the left-right direction (see arrow P1 shown in FIG. 2) in a state where the magnetic sensor 102 is mounted on the upper surface 2a of the bus bar 2. This eliminates the need to adjust the magnetic sensor 102 vertically upward or vertically downward with respect to the bus bar 2, and hence the installation area of the current sensor 1 can be reduced. Further, since the magnetic sensor 102 does not need to be adjusted away from the bus bar 2, the adjustment work is facilitated, and thus measurement errors are less likely to occur. Therefore, measurement accuracy can be improved.

After adjusting the sensitivity of the detection of the magnetic sensor 102, via elongated holes 102a provided in advance in the magnetic sensor 102 as shown in FIG. 2, the magnetic sensor 102 can be fixed to the upper surface 2a of the bus bar 2 by screws B shown in FIG. 2 into the left through-hole 2h1 and the right through-hole 2h2 shown in FIG. 1. Thus, when the left through-hole 2h1 and the right through-hole 2h2 are made to be served as a changer of the current path of the current I and served as a member for fixing the magnetic sensor 102 to the upper surface 2a of the bus bar 2 by screw, it will eliminate the need to provide other holes with separate roles in the bus bar 2, thereby simplifying the manufacturing process. In this case, the screw B is preferably made of plastic in which no current I flows so that the sensitivity of the detection of the adjusted magnetic sensor 102 is not deviated.

Thus, according to the present embodiment, which is not encompassed by the wording of the claims, the installation area of the current sensor can be reduced and the measurement accuracy can be improved.

Incidentally, the shape of the current sensor 1 shown in this embodiment, which is not encompassed by the wording of the claims, is merely an example, and various modifications and changes are possible without departing from the scope of the present invention as defined in the appended claims. For example, this embodiment, which is not encompassed by the wording of the claims, describes an example of screw fixing when the magnetic sensor 102 is fixed to the upper surface 2a of the bus bar 2 after adjusting the sensitivity of the detection of the magnetic sensor 102, but without being limited thereto, fixing by such as ultrasonic bonding, adhesive bonding may also be used. It is not necessary to provide the magnetic sensor 102 with an elongated hole 102a as shown in FIGS. 1 and 2 when the magnetic sensor 102 is fixed by such as ultrasonic bonding, adhesive bonding.

Further, this embodiment, which is not encompassed by the wording of the claims, describes an example of forming the left through-hole 2h1 and the right through-hole 2h2 in the bus bar 2, but without being limited thereto, either one of the left through-hole 2h1 or the right through-hole 2h2 may be formed, or much more through-holes may be formed.

Further, this embodiment, which is not encompassed by the wording of the claims, describes an example of forming the left through-hole 2h1 and the right through-hole 2h2 in the bus bar 2, but without being limited thereto, recessed hole that does not penetrate from the upper surface 2a to the lower surface 2b may be formed.

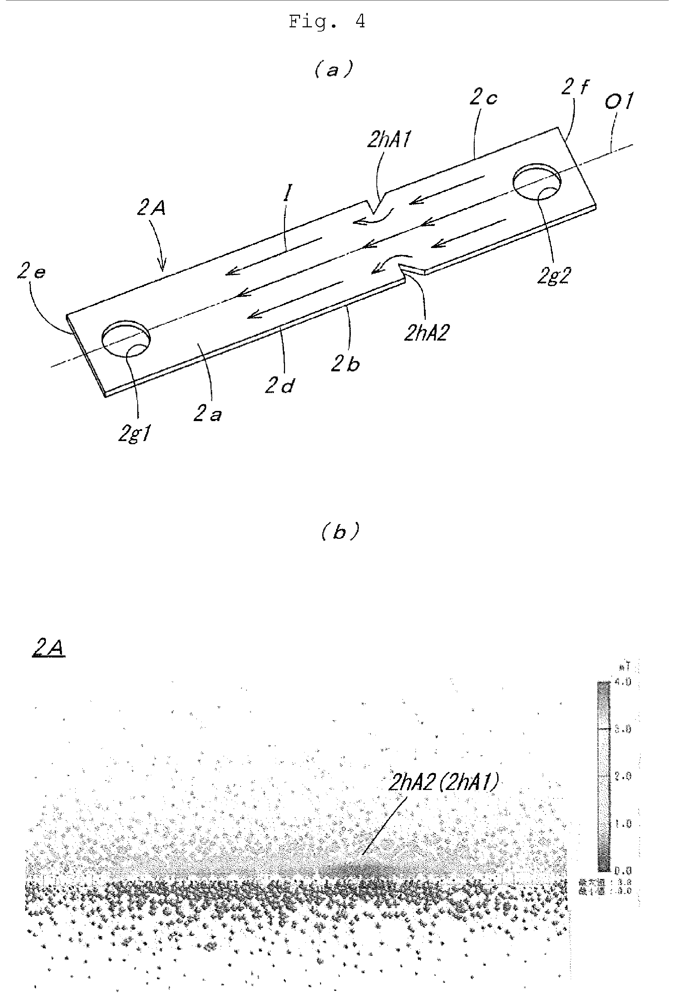

Further, this embodiment, which is not encompassed by the wording of the claims, describes an example of forming the left through-hole 2h1 and the right through-hole 2h2 in the bus bar 2, but without being limited thereto, like a bus bar 2A as shown in FIG. 4(a) may also be used. This will next be described specifically with reference to FIG. 4. It should be noted that components identical to bus bar 2 described in FIGS. 1-3 are designated by the same reference signs to omit the description thereof.

On the bus bar 2A shown in FIG. 4(a), an upper notch 2hA1 and a lower notch 2hA2 are newly formed instead of the left through-hole 2h1 and the right through-hole 2h2 in the bus bar 2 shown in FIGS. 1-3. This upper notch portion 2hA1 is a cutout from the upper side surface 2c of the busbar 2 toward the center line O1 in a right-angled triangular shape, and the lower notch 2hA2 is a cut out from the lower side surface 2d of the bus bar 2 toward the center line O1 in a right-angled triangular shape. The upper notch 2hA1 and the lower notch 2hA2 are placed by a mirror-image with respect to the center line O 1 as a base point.

In a configuration such that the upper notch 2hA1 and the lower notch 2hA2 set forth above are formed in the bus bar 2A, as shown in FIG. 4(a) when the current I to be measured flows linearly from the right side surface 2f of the bus bar 2 to the left side surface 2e, the current I that was linearly flowing avoids around the upper notch 2hA1 and flows into the center line O1 side of the bus bar 2A and the current I that was linearly flowing avoids around the lower notch 2hA2 and flows into the center line O1 side of the bus bar 2A.Thereby the current path of the current I is made to be changed by the upper notch 2hA1 and the lower notch 2hA2. Therefore, when the current I to be measured flows linearly from the right side surface 2f to the left side surface 2e of the bus bar 2A, a magnetic field component M (see FIG. 7) is generated in a direction perpendicular to the current I, while as will be apparent from a measurement result of the magnetic flux density shown in FIG. 4(b), by the concentration of the current I at the center line O1 side of the bus bar 2A a tense of the magnetic field component M in the vicinity where the upper notch 2hA1 and the lower notch 2hA2 are formed clearly becomes stronger as compared to other points. Accordingly, by forming the upper notch 2hA1 and the lower notch 2hA2 in the bus bar 2A, the variation of intensity of the magnetic field component M can be generated on the surface of the bus bar 2A.

Thus, in this way, the installation area of the current sensor can be reduced and the measurement accuracy can be improved.

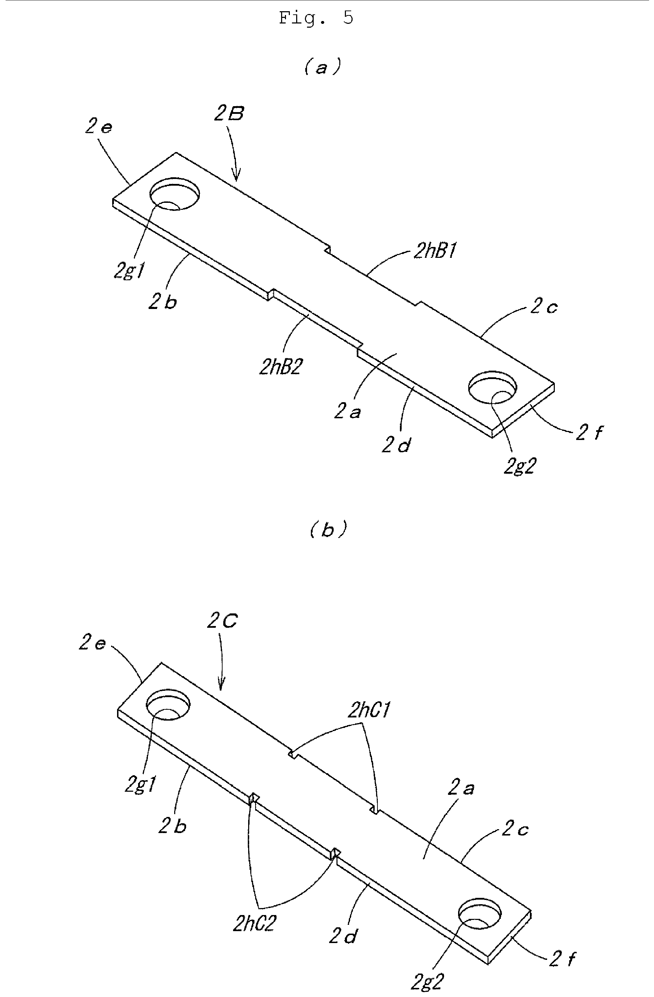

Incidentally, without being limited thereto, the upper notch 2hA1 and the lower notch 2hA2 shown in FIG. 4(a) may have any shapes. For example, an upper notch 2hB 1 and a lower notch 2hB2 may be formed in a recessed shape like a bus bar 2B shown in FIG. 5(a). Further, like a bus bar 2C shown in FIG. 5(b), an upper notches 2hC1 and a lower notches 2hC2 may be formed in a recessed shape and set longitudinally (from the right side surface 2f to the left side surface 2e of the bus bar 2C) at predetermined intervals. (In FIG. 5(a), a pair of the upper notch 2hB1 and the lower notch 2hB2 is arranged)

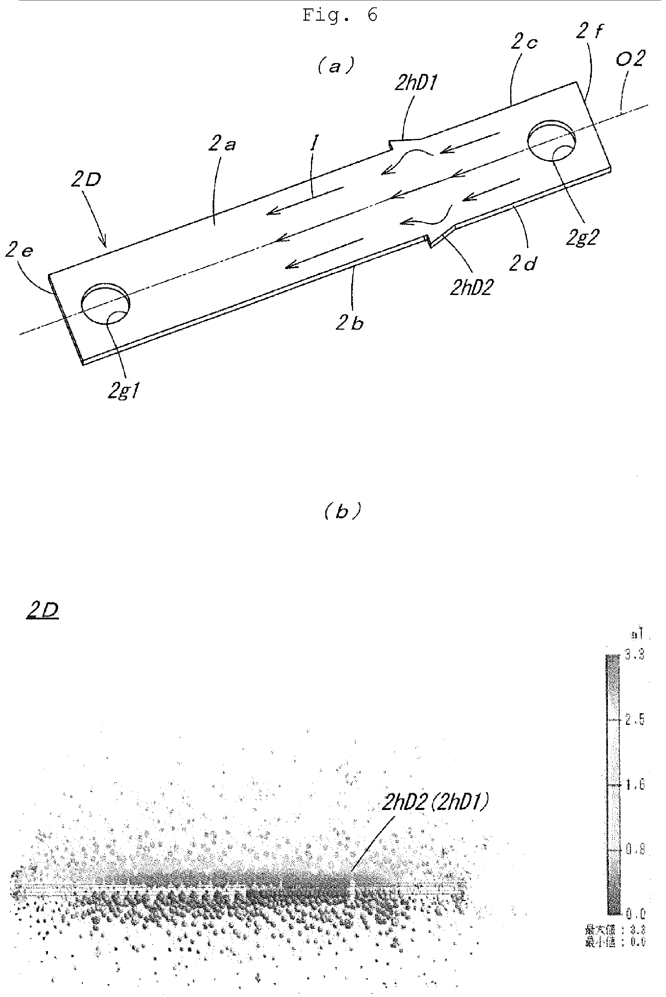

While, a bus bar 2D shown in FIG. 6(a) may also be used. This is specifically described with reference to FIG. 6. It should be noted that components identical to the bus bar 2 shown in FIGS. 1-3 are designated by the same reference signs to omit the description thereof.

A bus bar 2D shown in FIG. 6(a), an upper protrusion 2hD1 and a lower protrusion 2hD2 are newly formed instead of the left through-hole 2h1 and the right through-hole 2h2 in the bus bar 2 shown in FIGS. 1-3. This upper protrusion 2hD1 is protruding outwardly provided in a right triangular shape integrally formed from the upper side surface 2c of the bus bar 2D, and the lower protrusion 2hD2 is protruding outwardly provided in a right triangular shape integrally formed from the lower side surface 2d of the bus bar 2D. The upper protrusion 2hD1 and the lower protrusion 2hD2 are placed by a mirror-image with respect to the center line O2 as a base point.

In the configuration such that the upper protrusion 2hD1 and the lower protrusion 2hD2 are formed in the bus bar 2D set forth above, as shown in FIG. 6(a) when the current I to be measured flows linearly from the right side surface 2f to the left side surface 2e of the bus bar 2, the current I that was linearly flowing is curved by passing through the upper protrusion 2hD 1, and also the current I that was flowing linearly is curved by passing through the lower protrusion 2hD2. Thereby the current path of the current I is made to be changed by the upper protrusion 2hD1 and the lower protrusion 2hD2. Therefore, when the current I to be measured flows linearly from the right side surface 2f to the left side surface 2e of the bus bar 2D, a magnetic field component M (see FIG. 7) is generated in a direction perpendicular to the current I, while as will be apparent from a measurement result of the magnetic flux density shown in FIG. 6(b), a tense of the magnetic field component M in the vicinity of the upper protrusion 2hD1 and the lower protrusion 2hD2 clearly becomes weaker as compared to other points by the current I passing through the upper protrusion 2hD1 and the lower protrusion 2hD2. Accordingly, by forming the upper protrusion 2hD1 and the lower protrusion 2hD2 in the bus bar 2D, the variation of intensity of the magnetic field component M can be generated on the surface of the bus bar 2D.

Even in this way, the installation area of the current sensor can be reduced and the measurement accuracy can be improved.

### Reference Signs List

- 1: Current sensor
- 2, 2A, 2B, 2C, 2D: Bus bar
- 2a: Upper surface
- 2h1: Left through-hole (changer, through-hole)
- 2h2: Right through-hole (changer, through-hole)
- 2hA1: Upper notch (changer, notched portion)
- 2hA2: Lower notch (changer, notched portion)
- 2hB1: Upper notch (changer, notched portion)
- 2hB2: Lower notch (changer, notched portion)
- 2hC1: Upper notch (changer, notched portion)
- 2hC2: Lower notch (changer, notched portion)
- 2hD1: Upper protrusion (changer, protrusion)
- 2hD2: Lower protrusion (changer, protrusion)
- 102: Magnetic sensor

## Claims

1. A current sensor comprising:
a bus bar (2D) through which a current (I) to be measured flows; and
a magnetic sensor (102) for detecting a magnetic field component (M) generated by the current flowing through the bus bar, wherein the magnetic sensor (102) is mounted on an upper surface (2a) of the bus bar (2D), and
**characterized in that**
the bus bar (2D) is provided with an upper protrusion (2hD1) and a lower protrusion (2hD2) that are configured to change the flow of the current (I) to be measured.

## Patentansprüche

1. Stromsensor, umfassend:
eine Sammelschiene (2D), durch die ein zu messender Strom (I) fließt; und
einen Magnetsensor (102) zum Detektieren einer Magnetfeldkomponente (M), die durch den Strom erzeugt wird, der durch die Sammelschiene fließt, wobei der Magnetsensor (102) an einer oberen Fläche (2a) der Sammelschiene (2D) montiert ist, und
**dadurch gekennzeichnet, dass**
die Sammelschiene (2D) mit einem oberen Vorsprung (2hD1) und einem unteren Vorsprung (2hD2) versehen ist, die dazu ausgebildet sind, den Fluss des zu messenden Stroms (I) zu verändern.

## Revendications

1. Capteur de courant comprenant :
une barre omnibus (2D) à travers laquelle circule un courant (I) à mesurer ; et
un capteur magnétique (102) destiné à détecter une composante de champ magnétique (M) générée par le courant circulant à travers la barre omnibus, dans lequel le capteur magnétique (102) est monté sur une surface supérieure (2a) de la barre omnibus (2D), et
**caractérisé en ce que**
la barre omnibus (2D) est pourvue d'une saillie supérieure (2hD1) et d'une saillie inférieure (2hD2) qui sont configurées pour modifier la circulation du courant (I) à mesurer.
